# EUROPEAN PATENT APPLICATION

(11) **EP 4 692 830 A1**
(43) Date of publication of application: **11.02.2026**
(21) Application number: 24784806.2
(22) Date of filing: 27.03.2024
(51) Int. Cl.: G01R 33/02, G01N 27/72, G01R 33/09, G01V 3/10

(54) **MAGNETIC DETECTION SYSTEM**

(30) Priority: 04.04.2023 JP 2023060684
(71) Applicant: TDK Corporation, Tokyo 103-6128 (JP)
(72) Inventor: YAMAJI Yuichiro, Tokyo 103-6128 (JP); KAMI Masafumi, Tokyo 103-6128 (JP); KASAJIMA Tamon, Tokyo 103-6128 (JP); HARAKAWA Osamu, Binan, Laguna (PH)
(74) Representative: Epping - Hermann - Fischer
(86) International application number: PCT/JP2024/012291
(87) International publication number: WO 2024/210017

(57) **Abstract**

To provide a magnetic detection system capable of detecting a metallic foreign object with high sensitivity. A magnetic detection system 100 includes: a signal generation circuit 501 that generates an excitation signal P; an excitation coil 250 to which the excitation signal P is supplied; a buffer circuit 503 that is connected between the signal generation circuit 501 and the excitation coil 250; magnetic sensors 40A and 40B that are disposed on opposite sides of the excitation coil 250 along the coil axis direction; a sample stage 300 that holds a sample 310 between the excitation coil 250 and the first magnetic sensor 40A; and a detection circuit that generates a detection signal OUT based on the difference between output signals Pa and Pb output respectively from the magnetic sensors 40A and 40B. With this configuration, the buffer circuit 503 suppresses waveform distortion of the excitation signal P, thereby enabling detection of a metallic foreign object with high sensitivity.

## Description

### [Technical Field]

The present invention relates to a magnetic detection system and, more particularly, to a magnetic detection system capable of functioning as a foreign object detection system.

### [Background Art]

Patent Document 1 discloses a device including an excitation coil for applying a magnetic field to a sample, a magnetic sensor for detecting the magnetic field, and a cancellation coil for cancelling the magnetic field applied to the magnetic sensor. The magnetic sensor detects a magnetic field caused by an eddy current induced in a metallic foreign object contained in the sample, if such a metallic foreign object is present.

### [Citation List]

### [Patent Document]

[Patent Document 1] JP 2015-102513A

### [Disclosure of the Invention]

### [Problem to be Solved by the Invention]

However, to generate an eddy current in the metallic foreign object contained in the sample, it is necessary to cause a large current to flow through the excitation coil. Accordingly, if the drive capability of a signal generation circuit that generates an excitation signal is insufficient, the waveform of the excitation signal may become distorted, which can lead to measurement errors.

An object of the present disclosure is therefore to provide a magnetic detection system capable of detecting a metallic foreign object with high sensitivity by suppressing waveform distortion of the excitation signal.

### [Means for Solving the Problem]

A magnetic detection system according to an embodiment of the present disclosure includes: a signal generation circuit that generates an excitation signal; an excitation coil to which the excitation signal is supplied; a buffer circuit that is connected between the signal generation circuit, an output impedance of the buffer circuit being lower than an input impedance of the buffer circuit; first and second magnetic sensors that are disposed at locations where an excitation magnetic field generated by the excitation coil has the same amplitude; a sample stage that holds a sample between the excitation coil and the first magnetic sensor; and a detection circuit that generates a detection signal based on the difference between a first output signal output from the first magnetic sensor and a second output signal output from the second magnetic sensor.

### [Advantageous Effects of the Invention]

According to the present disclosure, a magnetic detection system that can detect metallic foreign object with high sensitivity can be provided since the buffer circuit suppresses disturbance of the waveform of the excitation signal.

### [Brief Description of the Drawings]

[FIG. 1]

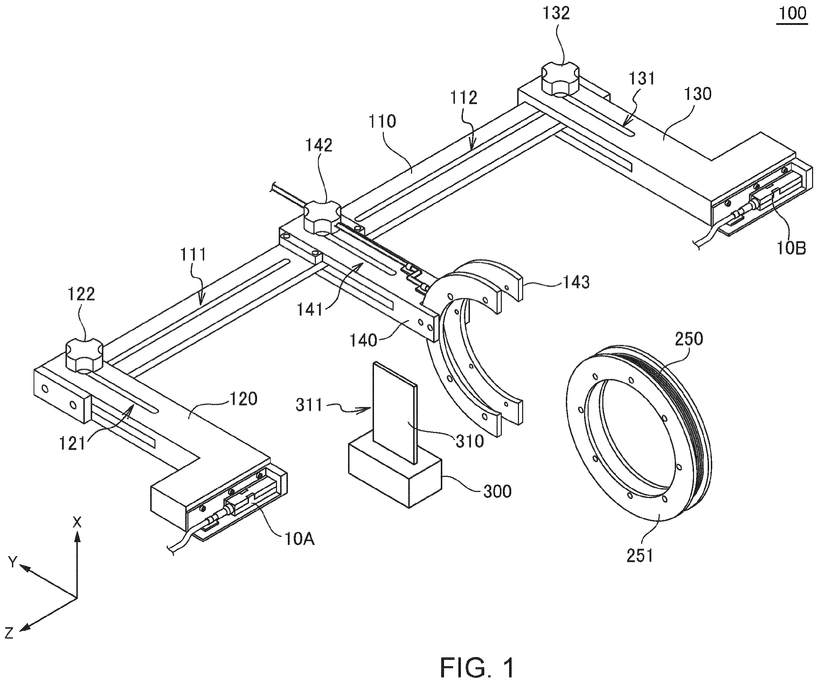

   FIG. 1 is a schematic exploded perspective view illustrating the outer appearance of a magnetic detection system 100 according to an embodiment of the present disclosure.
[FIG. 2]

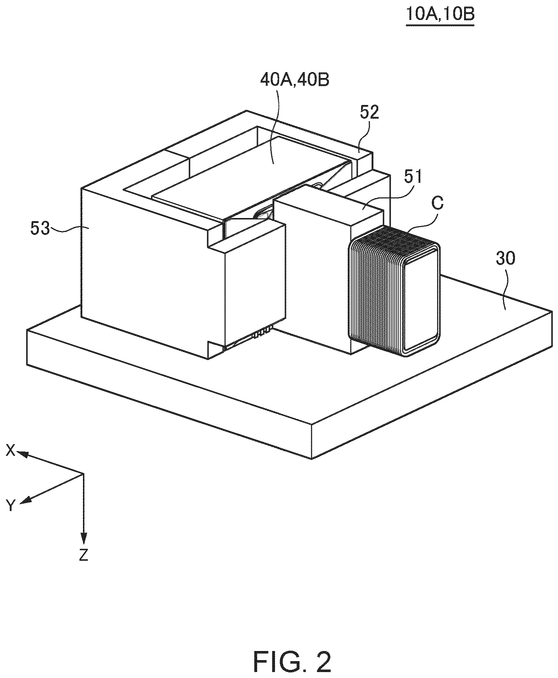

   FIG. 2 is a schematic perspective view for explaining the structure of the sensor main bodies 10A and 10B.
[FIG. 3]

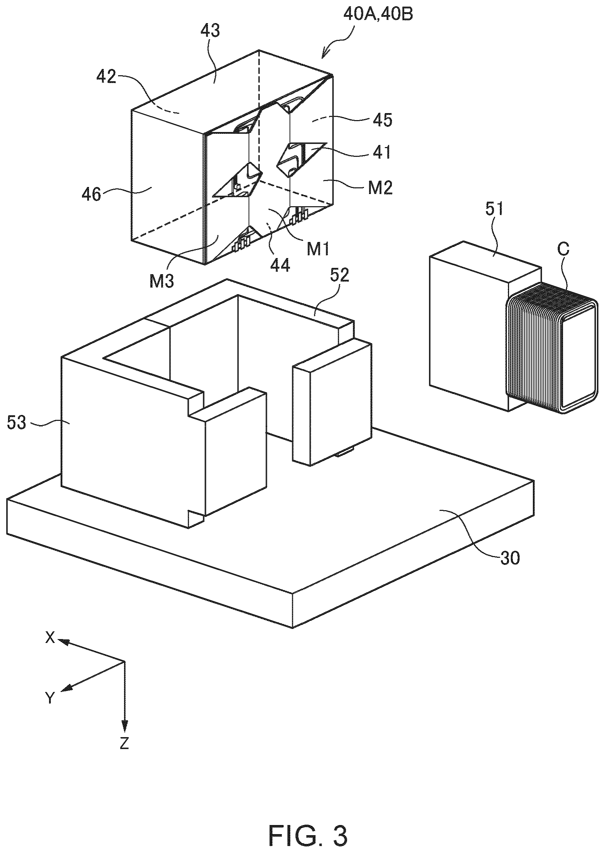

   FIG. 3 is an exploded perspective view for explaining the structure of the sensor main bodies 10A and 10B.
[FIG. 4]

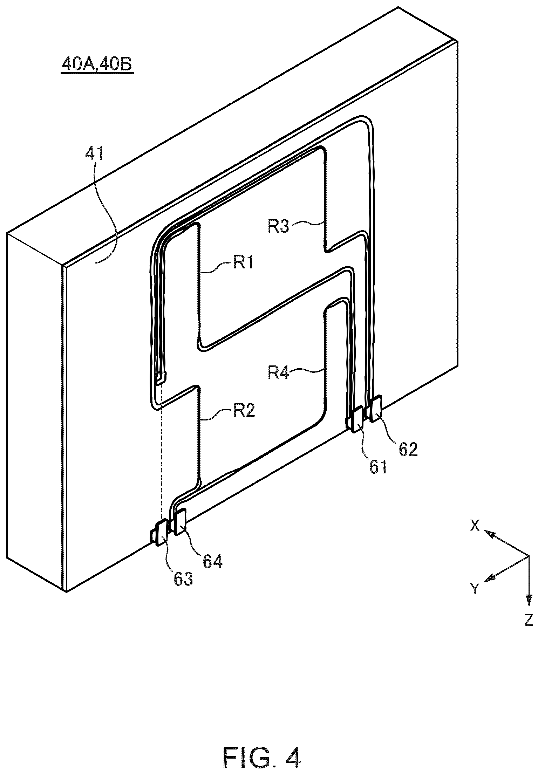

   FIG. 4 is a schematic perspective view illustrating a state in which the magnetic yokes M1 to M3 have been removed from the magnetic sensors 40A and 40B.
[FIG. 5]

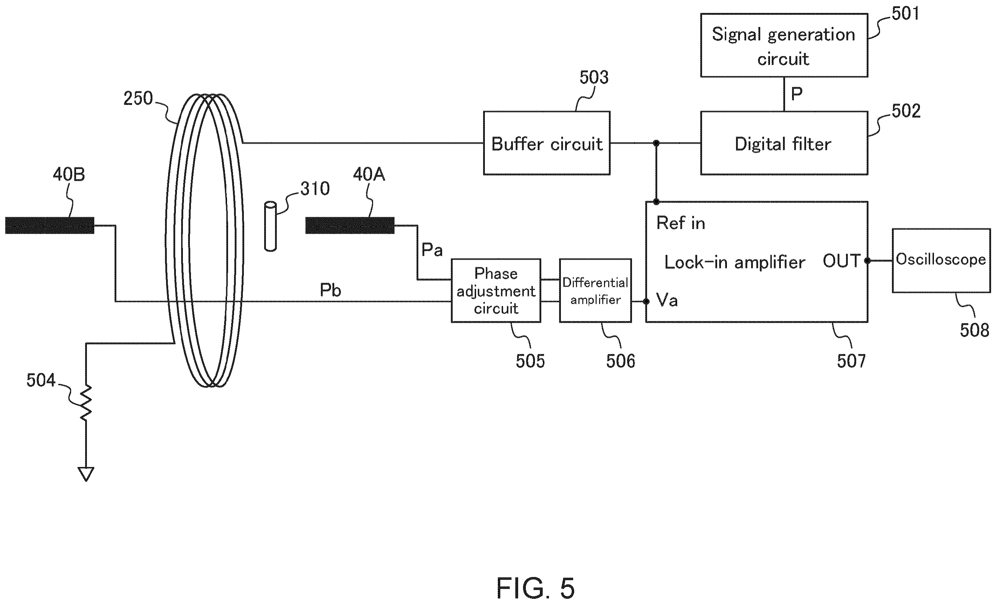

   FIG. 5 is a circuit block diagram of the magnetic detection system 100.
[FIG. 6]

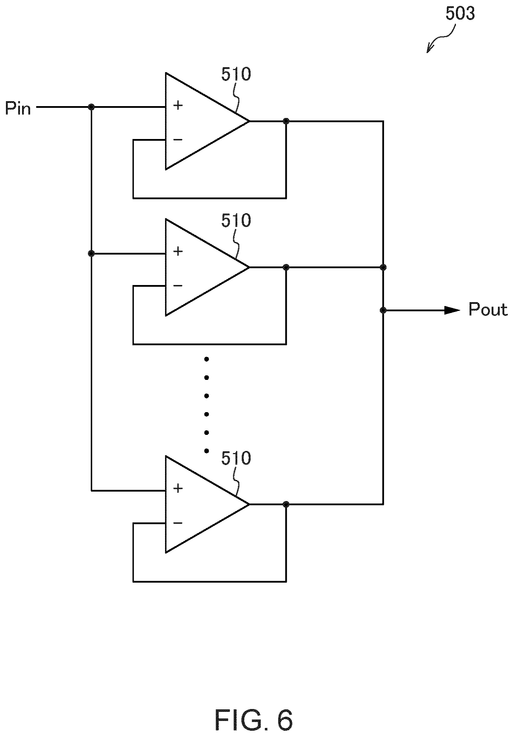

   FIG. 6 is a circuit diagram illustrating an example of the buffer circuit 503.
[FIG. 7]

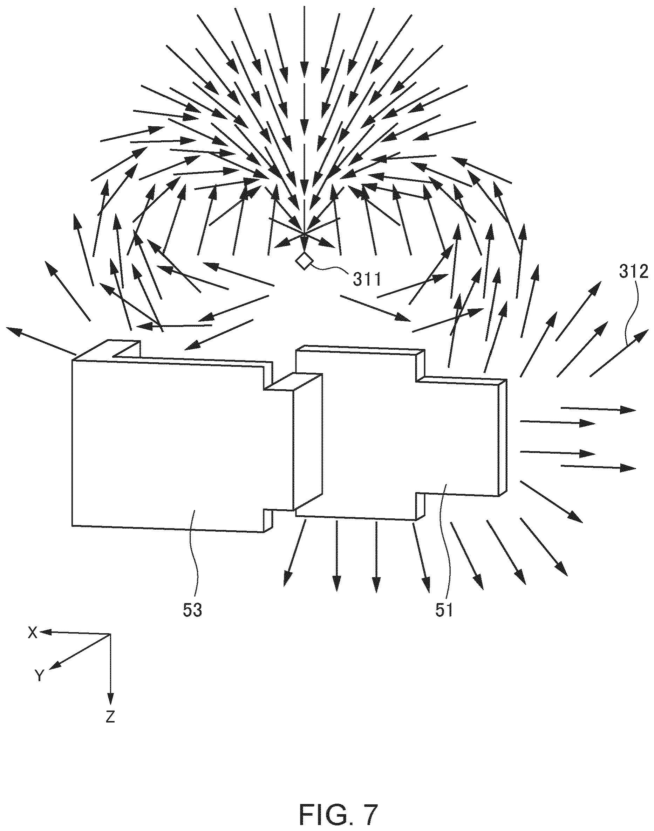

   FIG. 7 is a schematic diagram for explaining the magnetic field generated by the metallic foreign object 311.

### [Mode for Carrying Out the Invention]

Hereinafter, some embodiments of the present invention will be described in detail with reference to the accompanying drawings.

FIG. 1 is a schematic exploded perspective view illustrating the outer appearance of a magnetic detection system 100 according to an embodiment of the present disclosure.

As illustrated in FIG. 1, the magnetic detection system 100 according to the present embodiment includes an arm 110 elongated in the Z-direction and arms 120, 130, and 140 fixed to the arm 110. The arm 110 has guides 111 and 112 extending along the Z-direction. The arms 120 and 130 are respectively fastened to guides 111 and 112 with fixing screws 122 and 132. The fixing screws 122 and 132 are slidable along the guides 111 and 112, respectively. This enables the arms 120 and 130 to be moved in the Z-direction. Further, the arms 120, 130, and 140 respectively have guides 121, 131, and 141 extending along the Y-direction. The fixing screws 122 and 132, and a fixing screw 142 for fastening the arm 140 are slidable along the guides 121, 131, and 141, respectively. This enables the arms 120, 130, and 140 to be moved in the Y-direction.

Sensor main bodies 10A and 10B are respectively fixed to the leading ends of the arms 120 and 130 in the Y-direction. Further, a bobbin 251, around which an excitation coil 250 is wound, is fixed to the leading end of the arm 140 in the Y-direction. While the arm 140 and the bobbin 251 are illustrated as being separated in FIG. 1, the bobbin 251 is fixed to the leading end of the arm 140 in actual use.

The excitation coil 250 has its axis extending in the Z-direction, and the sensor main bodies 10A and 10B are disposed on opposite sides of the excitation coil 250 along the axial direction. The position of the excitation coil 250 in the Y-direction can be adjusted by sliding the arm 140 along the guide 141. The positions of the sensor main bodies 10A and 10B in the Z-direction can be adjusted by sliding the arms 120 and 130 along the guides 111 and 112, respectively. The positions of the sensor main bodies 10A and 10B in the Y-direction can be adjusted by sliding the arms 120 and 130 along the guides 121 and 131, respectively.

As a result, the positions of the sensor main bodies 10A and 10B in the XY plane direction are adjusted such that the center of the coil axis passes through both of them. The distances in the Z-direction between the excitation coil 250 and the sensor main body 10A, and between the excitation coil 250 and the sensor main body 10B, are adjusted so as to be equal. Thus, when current flows through the excitation coil 250, the magnetic field strengths of the excitation magnetic fields applied to the sensor main bodies 10A and 10B become equal to each other. The magnetic field strength may be defined by the amplitude of the excited magnetic field.

A sample stage 300 configured to hold a sample 310 is disposed between the excitation coil 250 and the sensor main body 10A. During measurement, the position of the arm 120 in the Z-direction is adjusted so that the sample 310 and the sensor main body 10A are brought close to each other in the Z-direction. Accordingly, the distance in the Z-direction between the sample 310 and the sensor main body 10A becomes significantly smaller than that between the sample 310 and the sensor main body 10B.

FIGS. 2 and 3 are views for explaining the structure of the sensor main bodies 10A and 10B, where FIG. 2 is a schematic perspective view, and FIG. 3 is an exploded perspective view.

As illustrated in FIGS. 2 and 3, the sensor main body 10A includes a chip-type magnetic sensor 40A and flux concentrators 51 to 53, all mounted on the surface of a sensor substrate 30. Similarly, the sensor main body 10B includes a chip-type magnetic sensor 40B and flux concentrators 51 to 53, all mounted on the surface of a sensor substrate 30. The magnetic sensors 40A and 40B are each a substantially rectangular parallelepiped and each have an element formation surface 41 and a back surface 42 which constitute the YZ plane, upper and lower surfaces 43 and 44 which constitute the XY plane, and side surfaces 45 and 46 which constitute the XZ plane. The element formation surface 41 is the surface on which magnetosensitive elements are formed. The magnetic sensors 40A and 40B are each mounted on the sensor substrate 30 such that the lower surface 44 faces the sensor substrate 30 and that the element formation surface 41 is perpendicular to the surface of the sensor substrate 30. Magnetic yokes M1 to M3 made of permalloy or the like are formed on the element formation surface 41 of each of the magnetic sensors 40A and 40B, and the magnetosensitive elements are disposed near magnetic gaps formed between the magnetic yokes M1 and M2 and between the magnetic yokes M1 and M3. With this configuration, magnetic flux that passes through the magnetic gaps is applied to the magnetosensitive elements.

FIG. 4 is a schematic perspective view illustrating a state in which the magnetic yokes M1 to M3 have been removed from the magnetic sensors 40A and 40B.

As illustrated in FIG. 4, in each of the magnetic sensors 40A and 40B, magnetosensitive elements R1 to R4 are formed on the element formation surface 41. The magnetosensitive elements R1 to R4 have their magnetic sensing directions oriented along the Y-direction. The magnetosensitive elements R1 and R2 are disposed near the magnetic gap formed between the magnetic yokes M1 and M2, and the magnetosensitive elements R1 and R2 are disposed near the magnetic gap formed between the magnetic yokes M1 and M3. The magnetosensitive elements R1 to R4 are bridge-connected between terminal electrodes 61 and 62, and differential signals corresponding to a magnetic field appear at terminal electrodes 63 and 64.

The flux concentrators 51 to 53 are each a block made of a magnetic material such as ferrite, and act to concentrate a magnetic field generated from the sample 310 onto the magnetic sensors 40A and 40B. The flux concentrators 51 to 53 respectively overlap the magnetic yokes M1 to M3 as seen from the X-direction. That is, the flux concentrators 51 to 53 are arranged in the Y-direction on the element formation surface 41, with the magnetosensitive elements R3 and R4 disposed between the flux concentrators 51 and 52, and the magnetosensitive elements R1 and R2 disposed between the flux concentrators 51 and 53, as seen from the X-direction.

The flux concentrator 51 is elongated in the X-direction and mainly acts to concentrate a magnetic field in the X-direction onto the magnetic yoke M1. The flux concentrator 52 has portions that cover the side surface 45 and back surface 42 of each of the magnetic sensors 40A and 40B, and the flux concentrator 53 has portions that cover the side surface 46 and back surface 42 of each of the magnetic sensors 40A and 40B. With this configuration, the magnetic field in the X-direction concentrated by the flux concentrator 51 is redirected toward the Y-direction by the magnetic yoke M1 and guided to the flux concentrators 52 and 53 through the magnetic yokes M2 and M3. Then, the magnetic fields passing through the magnetic gaps formed between the magnetic yokes M1 and M2 and between the magnetic yokes M1 and M3 are detected by the magnetosensitive elements R1 to R4. In the example illustrated in FIGS. 2 and 3, a compensation coil C is wound around the flux concentrator 51. The compensation coil C is supplied with a cancellation current to cancel the magnetic fields applied to the magnetosensitive elements R1 to R4.

The sensor main body 10A thus configured is moved in the Z-direction using the arm 120 to be brought close to the sample 310. It is preferable that the distance in the Z-direction between the sample 310 and sensor main body 10A be as small as possible within the range that prevents interference between them. The sample 310 may sometimes contain a metallic foreign object.

FIG. 5 is a circuit block diagram of the magnetic detection system 100 according to the present embodiment.

As illustrated in FIG. 5, the magnetic detection system 100 according to the present embodiment includes a signal generation circuit 501 that generates an excitation signal P having a predetermined frequency. The excitation signal P is supplied to one end of the excitation coil 250 through a digital filter 502 and a buffer circuit 503. The other end of the excitation coil 250 is grounded through a resistor 504. The excitation signal P may be a sine wave or a rectangular wave. The digital filter 502 is a circuit for removing unnecessary frequency components included in the excitation signal P and has a band-pass filter function. The buffer circuit 503 is a circuit configured to increase the current without changing the voltage waveform of the excitation signal P and has a lower output impedance than its input impedance.

FIG. 6 is a circuit diagram illustrating an example of the buffer circuit 503. In the example illustrated in FIG. 6, the buffer circuit 503 includes a plurality of voltage follower circuits 510 connected in parallel. This enables more current to be supplied to the excitation coil 250 while maintaining the voltage waveform of an output excitation signal Pout identical to that of an input excitation signal Pin. The current supplied to the excitation coil 250 can be adjusted by changing the number of the voltage follower circuits 510 connected in parallel. The voltage follower circuit 510 may be used alone depending on the required current or its capability.

When the excitation signal P flows through the excitation coil 250, a magnetic field is generated around the excitation coil 250 and applied to the two magnetic sensors 40A and 40B. As described above, the magnetic field generated by the excitation coil 250 is evenly applied to the magnetic sensors 40A and 40B. Thus, if the sample 310 is absent, output signals Pa and Pb output from the magnetic sensors 40A and 40B, respectively, have the same level.

The output signals Pa and Pb are input to a differential amplifier 506 through a phase adjustment circuit 505. Since the distances in the Z-direction between the excitation coil 250 and the magnetic sensor 40A, and between the excitation coil 250 and the magnetic sensor 40B, are equal, the output signals Pa and Pb are expected to be in phase. On the other hand, if any phase difference occurs due to variations in the position adjustment of the arms 120 and 130, the phase adjustment circuit 505 is used to make the output signals Pa and Pb become in phase.

The differential amplifier 506 is a circuit configured to extract the difference between the output signals Pa and Pb, and the resulting differential signal Va is supplied to a lock-in amplifier 507. If the sample 310 is absent, the output signals Pa and Pb have the same level, so that the differential signal Va output from the differential amplifier 506 becomes zero.

The lock-in amplifier 507 is a circuit configured to extract the same frequency component as that of the excitation signal P included in the differential signal Va using the excitation signal P as a reference and to generate a detection signal OUT. The waveform of the detection signal OUT is displayed on an oscilloscope 508. The differential amplifier 506 and lock-in amplifier 507 constitute a detection circuit that generates the detection signal OUT based on the difference between the output signals Pa and Pb. Although the detection circuit is constituted by the differential amplifier 506 and lock-in amplifier 507 in the example illustrated in FIG. 5, the present invention is not limited thereto.

If the sample 310 contains a metallic foreign object, an eddy current is generated in the metallic foreign object by the magnetic field from the excitation coil 250. This eddy current generates another magnetic field, which is detected by the magnetic sensor 40A. The sample 310 is disposed between the excitation coil 250 and the magnetic sensor 40A. Accordingly, the sample 310 and magnetic sensor 40B are sufficiently separated from each other, so that the magnetic field generated by the eddy current is not substantially applied to magnetic sensor 40B. Thus, when the sample 310 contains a metallic foreign object, the magnetic field component caused by the eddy current generates a difference between the output signals Pa and Pb, and this difference appears as the detection signal OUT.

As described above, using the magnetic detection system 100 according to the present embodiment makes it possible to detect, with high sensitivity, the presence of a metallic foreign object when it is contained in the sample 310. Further, since the magnetic sensor 40A detects the magnetic field caused by the eddy current, even when the metallic foreign object is made of a nonmagnetic material such as aluminum or copper, it can be detected. Furthermore, in the present embodiment, the excitation signal P output from the signal generation circuit 501 is not supplied directly to the excitation coil 250; instead, it is supplied through the buffer circuit 503 having a high drive capability, so that even when a large current is supplied to the excitation coil 250, unnecessary fluctuations are hardly caused in the magnetic field generated by the excitation coil 250. This reduces measurement errors caused by unnecessary fluctuations in the magnetic field, and thus, even a minute metallic foreign object contained in the sample 310 can be detected with high sensitivity.

The positional relationship between the metallic foreign object 311 and the sensor main body 10A is in the Z-direction. However, by sufficiently reducing the distance in the Z-direction between the sample 310 and the sensor main body 10A, it is possible, as illustrated in the schematic view of FIG. 7, to concentrate the X-direction component of the magnetic field generated by the metallic foreign object 311 by the flux concentrators 51 to 53 and apply it to the magnetosensitive elements R1 to R4. In FIG. 7, reference numeral 312 denotes the direction and strength of the magnetic field generated by the metallic foreign object 311. By thus setting the longitudinal direction (X-direction) of the flux concentrator 51 perpendicular to the separating direction (Z-direction) between the sample 310 and the sensor main body 10A, it is possible to reduce the distance between the sample 310 and the magnetosensitive elements R1 to R4 to thereby achieve high detection sensitivity. In particular, by arranging the center of the coil axis of the excitation coil 250 to pass between the element formation surface 41 of the magnetic sensor 40A and the flux concentrator 51 and between the element formation surface 41 of the magnetic sensor 40B and the flux concentrator 51, higher detection sensitivity can be achieved.

As described above, the magnetic detection system 100 according to the present embodiment is configured such that the magnetic sensors 40A and 40B are disposed on opposite sides of the excitation coil 250 along the coil axis direction, with the sample 310 positioned between the excitation coil 250 and the magnetic sensor 40A. With this configuration, it is possible to detect an eddy current induced in a metallic foreign object contained in the sample 310, if such a metallic foreign object is present. Thus, even when the metallic foreign object is made of a nonmagnetic material, it can be detected with high sensitivity.

Further, the magnetic sensors 40A, 40B, and the excitation coil 250 are respectively fixed to the movable arms 120, 130, and 140, enabling fine adjustment of the relative positions among the magnetic sensors 40A, 40B, and the excitation coil 250.

While some embodiment of the present disclosure has been described, the present disclosure is not limited to the above embodiment, and various modifications may be made within the scope of the present disclosure, and all such modifications are included in the present disclosure.

For example, although, in the above embodiment, the sensor main bodies 10A and 10B are arranged so as to be opposed across the excitation coil 250 in the coil axis direction, the arrangement of the sensor main bodies 10A and 10B is not particularly limited to such a configuration, provided that they are located at positions where the excitation magnetic fields generated by the excitation coil 250 have equal amplitudes.

The technology according to the present disclosure includes the following configuration examples but not limited thereto.

A magnetic detection system according to an embodiment of the present disclosure includes: a signal generation circuit that generates an excitation signal; an excitation coil to which the excitation signal is supplied; a buffer circuit that is connected between the signal generation circuit, an output impedance of the buffer circuit being lower than an input impedance of the buffer circuit; first and second magnetic sensors that are disposed at locations where an excitation magnetic field generated by the excitation coil has the same amplitude; a sample stage that holds a sample between the excitation coil and the first magnetic sensor; and a detection circuit that generates a detection signal based on the difference between a first output signal output from the first magnetic sensor and a second output signal output from the second magnetic sensor. With this configuration, the buffer circuit suppresses waveform distortion of the excitation signal, thereby enabling detection of a metallic foreign object with high sensitivity.

In the above magnetic detection system, the first and second magnetic sensors may be disposed on opposite sides of the excitation coil along the coil axis direction. This easily enables the excitation magnetic fields applied to the respective magnetic sensors to have equal amplitudes.

In the above magnetic detection system, the buffer circuit may include a single voltage follower circuit or a plurality of voltage follower circuits connected in parallel. This enables easy adjustment of the current flowing through the excitation coil.

The above magnetic detection system may further include first and second flux concentrators that concentrate magnetic flux onto the first and second magnetic sensors, respectively, each of the first and second magnetic sensors may be disposed such that an element formation surface on which a magnetosensitive element is formed is parallel to the coil axis, the first flux concentrator may be disposed on the element formation surface of the first magnetic sensor, the second flux concentrator may be disposed on the element formation surface of the second magnetic sensor, the center of the coil axis may be positioned between the element formation surface of the first magnetic sensor and the first flux concentrator and between the element formation surface of the second magnetic sensor and the second flux concentrator. This enables higher-sensitivity detection.

The above magnetic detection system may further include a phase adjustment circuit that adjusts the phases of the first and second output signals. This enables cancellation of the phase difference caused by variations in position adjustment.

The above magnetic detection system may further include a first arm having first and second guides extending along the coil axis direction, a second arm, with the first magnetic sensor fixed thereto, configured to be movable in the coil axis direction along the first guide, and a third arm, with the second magnetic sensor fixed thereto, configured to be movable in the coil axis direction along the second guide. This configuration enables the positions of the first and second magnetic sensors in the coil axis direction to be changed.

The above magnetic detection system may further include a fourth arm fixed to the excitation coil, and the second to fourth arms may be fixed to the first arm so as to be movable in a first direction perpendicular to the coil axis direction. This enables the positions of the first magnetic sensor, second magnetic sensor, and excitation coil in the first direction to be changed.

### [Reference Signs List]

10A, 10B sensor main body
30 sensor substrate
40A, 40B magnetic sensor
41 element formation surface
42 back surface
43 upper surface
44 lower surface
45, 46 side surface
51-53 flux concentrator
61-64 terminal electrode
100 magnetic detection system
111, 112, 121, 131, 141 guide
120, 130, 140 arm
122, 132, 142 fixing screw
250 excitation coil
300 sample stage
310 sample
311 metallic foreign object
312 magnetic field
501 signal generation circuit
502 digital filter
503 buffer circuit
504 resistor
505 phase adjustment circuit
506 differential amplifier
507 lock-in amplifier
508 oscilloscope
510 voltage follower circuit
C compensation coil
M1-M3 magnetic yoke
R1-R4 magnetosensitive element

## Claims

1. A magnetic detection system comprising:
a signal generation circuit configured to generate an excitation signal;
an excitation coil supplied with the excitation signal;
a buffer circuit connected between the signal generation circuit and the excitation coil, an output impedance of the buffer circuit being lower than an input impedance of the buffer circuit;
first and second magnetic sensors disposed at locations where an excitation magnetic field generated by the excitation coil has a same amplitude;
a sample stage holding a sample between the excitation coil and the first magnetic sensor; and
a detection circuit configured to generate a detection signal based on a difference between a first output signal output from the first magnetic sensor and a second output signal output from the second magnetic sensor.

2. The magnetic detection system as claimed in claim 1, wherein the first and second magnetic sensors are disposed on opposite sides of the excitation coil along a coil axis direction.

3. The magnetic detection system as claimed in claim 1, wherein the buffer circuit includes a single voltage follower circuit or a plurality of voltage follower circuits connected in parallel.

4. The magnetic detection system as claimed in claim 1, further comprising first and second flux concentrators configured to concentrate magnetic flux onto the first and second magnetic sensors, respectively,
wherein each of the first and second magnetic sensors is disposed such that an element formation surface on which a magnetosensitive element is formed is parallel to the coil axis,
wherein the first flux concentrator is disposed on the element formation surface of the first magnetic sensor,
wherein the second flux concentrator is disposed on the element formation surface of the second magnetic sensor, and
wherein a center of the coil axis is positioned between the element formation surface of the first magnetic sensor and the first flux concentrator and between the element formation surface of the second magnetic sensor and the second flux concentrator.

5. The magnetic detection system as claimed in claim 1, further comprising a phase adjustment circuit configured to adjust phases of the first and second output signals.

6. The magnetic detection system as claimed in any one of claims 1 to 5, further comprising:
a first arm having first and second guides extending along the coil axis direction;
a second arm, with the first magnetic sensor fixed thereto, configured to be movable in the coil axis direction along the first guide; and
a third arm, with the second magnetic sensor fixed thereto, configured to be movable in the coil axis direction along the second guide.

7. The magnetic detection system as claimed in claim 6, further comprising a fourth arm fixed to the excitation coil,
wherein the second to fourth arms are fixed to the first arm so as to be movable in a first direction perpendicular to the coil axis direction.
